# EUROPEAN PATENT APPLICATION

(11) **EP 1 100 125 A1**
(43) Date of publication of application: **16.05.2001**
(21) Application number: 99830699.7
(22) Date of filing: 10.11.1999
(51) Int. Cl.: H01L 23/544, G06F 11/00, G11C 17/10

(54) **Integrated circuit with identification signal writing circuitry distributed on multiple metal layers**

(71) Applicant: STMicroelectronics S.r.l., 20041 Agrate Brianza (Milano) (IT)
(72) Inventor: Vai, Gianfranco, 27100 Pavia (IT); Savo, Pierandrea, 27100 Pavia (IT)
(74) Representative: Pezzoli, Ennio

(57) **Abstract**

Integrated device (100) comprising a plurality of conducting layers (115a-115c), each having a first (120ga-120gc) and a second (120va-120vc) power supply contact for providing, respectively, a first and a second binary value, and means for supplying at least one identification bit of a version of the integrated device (100); the integrated device (100) includes, for each identification bit, parity check means (135abi, 135bci) having a plurality of input terminals whose number is equal to the number of conducting layers (115a-115c), and an output terminal, each input terminal being connected to one contact selected from the first (120ga-120gc) and the second (120va-120vc) power supply contacts of a corresponding one of the conducting layers (115a-115c), and the output terminal supplying the corresponding identification bit.

## Description

The present invention relates to an integrated device.

Integrated devices are generally made in different versions (during a development phase, for example), each of which is identified by a corresponding number. The version number is normally printed on a package wherein the integrated device is encapsulated.

Typically, the version number is also stored in binary form in a read-only register within the integrated device. The read-only register consists of a plurality of binary cells, each of which stores a corresponding bit of the version number. The binary cell is electrically connected to a reference terminal (logical value 0) or to a terminal of a power source (logical value 1). This enables a control unit, connected to the integrated device by a bus, to read the version number automatically. This information is then used by the control unit to program the integrated device in a corresponding way, for example by changing the content of configuration registers within it.

The change from one version of the integrated device to the immediately following version generally involves the modification of one or more layers, such as the metal connecting layers, each of which is formed by using a corresponding mask. These masks are very expensive, and therefore with each change of version an attempt is made to keep the number of modified layers as small as possible.

This makes it extremely difficult to modify in a corresponding way the content of the read-only register in which the version number of the integrated device is stored. As an example, we may consider the case in which the next version of the integrated device requires the modification of few metal layers (only one in the worst case); in this situation, it is very frequently impossible to modify the connections of the cells of the read-only register to the reference terminal or to the power supply terminal by using only the metal layers which have already been modified to meet circuit requirements. This disadvantage is accentuated by the layout complexity of the integrated device (which is generally directly proportional to the number of metal layers available).

Consequently, the known solution requires the modification of further metal layers (not changed to meet circuit requirements). This entails the making of a larger number of new masks, with a consequent increase in the cost of the integrated device.

The object of the present invention is to overcome the aforesaid drawbacks. To achieve this object, an integrated device as described in the first claim is proposed.

Briefly, there is provided an integrated device comprising a plurality of conducting layers, each having a first and a second power supply contact for providing, respectively, a first and a second binary value, and means for supplying at least one identification bit of a version of the integrated device; the integrated device includes, for each identification bit, parity check means having a plurality of input terminals whose number is equal to the number of conducting layers, and an output terminal, each input terminal being connected to one contact selected from the first and the second power supply contacts of a corresponding one of the conducting layers, and the output terminal supplying the corresponding identification bit.

The present invention also proposes a corresponding method for identifying an integrated device.

Further characteristics and the advantages of the integrated device according to the present invention will be made clear by the following description of a preferred embodiment of the invention, provided for guidance and without restrictive intent, with reference to the attached figures, in which:

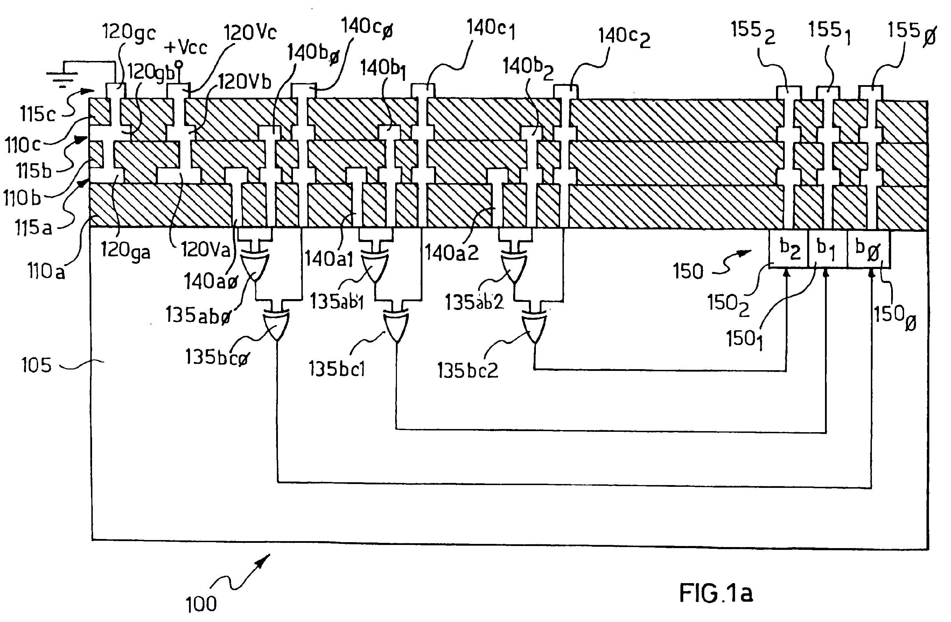

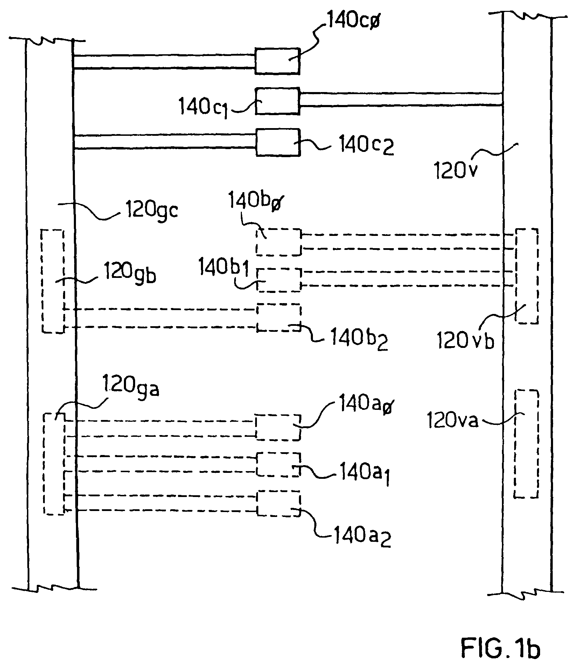

Figs. 1a and 1b show schematically the integrated device, in cross section and in plan view respectively.

With reference in particular to Fig. 1a, an integrated device 100 formed in a chip of semiconductor material 105 (typically silicon) is shown. The chip 105 is covered with a layer of insulating material 110a (for example, silicon oxide). Windows for surface contact with the chip 105 are made in the insulating layer 110a by a photolithographic masking process and an etching phase. A thin layer of metallic material 115a (for example aluminium) is deposited on top of the insulating layer 110a. The metal layer 115a is then shaped by a photolithographic masking process and an etching phase.

The chip 105 is covered with a further insulating layer 110b (generally planarized). Through holes for connection to the underlying metal layer 115a are made in the insulating layer 110b. A further metal layer 115b is deposited on top of the insulating layer 110b, in such a way as to fill the through holes made in the insulating layer 110b, and is then suitably shaped. Similarly, the chip 105 is covered with a further insulating layer 110c, in which various through holes are made for connection to the underlying metal layer 115b. A further metal layer 115c is deposited on top of the insulating layer 110c, and is shaped in such a way as to form various contact pads for connecting the integrated device 100 to the exterior.

The metal layers 115a, 115b and 115c include, respectively, two power supply strips 120ga, 120va, two power supply strips 120gb, 120vb, and two power supply strips 120gc, 120vc.

The power supply strip 120gc is connected to a reference terminal (or ground). The power supply strip 120gb is connected to the power supply strip 120gc (and consequently to the ground terminal) by means of a metallized hole (or via) formed in the insulating layer llOc; similarly, the power supply strip 120ga is connected to the power supply strip 120gb (and consequently to the ground terminal) by means of a via formed in the insulating layer 110b.

The power supply strip 120vc is connected to the positive terminal of a direct-current power source +Vcc (at 5 V, for example), whose negative terminal is connected to the ground terminal. The power supply strip 120vb is connected to the power supply strip 120vc (and consequently to the power source +Vcc) by means of a via formed in the insulating layer 110c; similarly, the power supply strip 120va is connected to the power supply strip 120vb (and consequently to the power source +Vcc) by means of a via formed in the insulating layer 110b.

The potential of the ground terminal and the potential of the power source +Vcc represent logical values of 0 and 1 respectively.

Similar considerations are applicable in cases in which a different number of metal layers is provided, in which layers delimited by regions inside the chip of semiconductor material (doped with P-type or N-type impurities), or more generally other conducting layers are considered, in which the power supply strips are replaced by equivalent contacts, in which the integrated device is of the hybrid type, in which the logical values 0 and 1 are associated with different voltages, or similar.

The integrated device 100 comprises a read-only register 150 formed by one or more binary cells 150i (where i=0...2 in the illustrated example). Each binary cell 150i stores a corresponding bit bi; the bits b2-b0 (where b0 is the least significant bit and b2 is the most significant bit) represent a version number of the integrated device 100 (from 000 to 111). The version number b2blb0 identifies, for example, a modification of the integrated device during a development phase, a customizing of a sea-of-gates circuit in which the connections between the various components are determined by a further metal mask (semi-custom), or similar.

Two logical XOR gates 135abi and 135bci, in other words a number of logical XOR gates equal to the number of metal layers 110a-110c minus 1, are associated with each version identification bit bi. A first input terminal of the logical XOR gate 135abi is connected to a connecting pad 140ai (formed in the metal layer 115a). A second input terminal of the logical XOR gate 135abi is connected to a connecting pad 140bi (formed in the metal layer 115b), by means of a via formed in the insulating layers 110a, ll0b.

An output terminal of the logical XOR gate 135abi is connected to a first input terminal of the logical XOR gate 135bci. A second input terminal of the logical XOR gate 135bci is connected to a connecting pad 140ci (formed in the metal layer 110c) , by means of a via formed in the insulating layers 110a-110c.

An output terminal of the logical XOR gate 135bci is connected to the input of the binary cell 150i. The binary cell 150i is connected to a contact pad 155i (formed in the metal layer 115c), by means of a via formed in the insulating layers 110a-110c. The contact pad 155i supplies the corresponding version identification bit bi to the exterior of the integrated device 100.

Each connecting pad 140ai-140ci can be connected to the power supply strip 120ga-120gc or to the power supply strip 120va-120vc of the corresponding metal layer 115a-115c; thus each input terminal of the logical XOR gates 135abi, 135bci is brought to the logical level 0 or 1 respectively. The logical XOR gates 135abi, 135bci associated with each version identification bit bi form a combinatorial network having three input terminals (their number being equal to the number of metal layers), each connected to one strip selected from the power supply strips of the corresponding metal layer, and one output terminal, connected to the corresponding binary cell; this combinatorial network is defined by the following truth table:

| 140ai | 140bi | 140ci | bi |
|---|---|---|---|
| 0 | 0 | 0 | 0 |
| 0 | 0 | 1 | 1 |
| 0 | 1 | 0 | 1 |
| 0 | 1 | 1 | 0 |
| 1 | 0 | 0 | 1 |
| 1 | 0 | 1 | 0 |
| 1 | 1 | 0 | 0 |
| 1 | 1 | 1 | 1 |

As can be seen, the logical value at the output terminal (which supplies the version identification bit bi) switches (from 0 to 1 or vice versa) whenever the logical value of one of the input terminals changes.

In the example shown in Fig. 1b, the connecting pads 140a0-140a2 are all connected to the power supply strip 120ga, the connecting pad 140b2 is connected to the power supply strip 120gb, while the connecting pads 140b0, 140b1 are connected to the power supply strip 120vb, the connecting pads 140c0, 140c2 are connected to the power supply strip 120gc, while the connecting pad 140c1 is connected to the power supply strip 120vc. Thus the version identification bits b2, b1, b0 assume the logical values shown in the following table:

| | | | | | |
|---|---|---|---|---|---|
| 140a2: | 0 | 140a1: | 0 | 140a0: | 0 |
| 140b2: | 0 | 140b1: | 1 | 140b0: | 1 |
| 140c2: | 0 | 140c1: | 1 | 140c0: | 0 |
| b2: | 0 | b1: | 0 | b0: | 1 |

and therefore the integrated device 100 is identified by the version number 001 (version 1).

It will now be assumed that the next version of the integrated device 100 (version 2) is produced, being obtained from the preceding version by modifying the metal layer 115b (while the metal layers 115a and 115c are unchanged). In order for the version identification bits b2, b1, b0 to assume the corresponding logical value 0, 1, 0, it is only necessary to modify the connections of the connecting pads 140b0-140b2 to the power supply strip 120gb and to the power supply strip 120vb of the corresponding metal layer 115b. In particular, the connecting pads 140b0-140b2 are all connected to the power supply strip 120gb. Thus the version identification bits b2, b1, b0 assume the logical values shown in the following table:

| | | | | | |
|---|---|---|---|---|---|
| 140a2: | 0 | 140a1: | 0 | 140a0: | 0 |
| 140b2: | 0 | 140b1: | 0 | 140b0: | 0 |
| 140c2: | 0 | 140c1: | 1 | 140c0: | 0 |
| b2: | 0 | b1: | 1 | b0: | 0 |

Similar considerations are applicable in a case in which the input terminals of the logical XOR gates are connected in another way to the power supply strip, in which a different combinatorial network, or more generally equivalent parity check means which supply at the output a logical value differing according to the number (even or odd) of input terminals having the logical value 1, is provided, in which no register is provided (the output terminals of the logical XOR gates being connected directly to the corresponding contact pads), or similar.

The solution according to the present invention makes it extremely simple to modify the version number of the integrated device. This result is achieved by using only the metal layers which have already been modified to meet the requirements of the circuit (down to a single metal layer).

Consequently this solution does not require the modification of further metal layers (which have not been changed to meet the requirements of the circuit), thus keeping to a minimum the number of new masks to be produced.

The particular embodiment using logical XOR gates is also extremely simple, and occupies a small area on the chip of semiconductor material in which the integrated device is formed.

Of course, a person skilled in the art may, in order to meet contingent and specific requirements, make numerous modifications and variations to the integrated device described above, all these modifications and variations being contained within the scope of protection of the invention, as defined by the following claims.

## Claims

1. Integrated device (100) comprising a plurality of conducting layers (115a-115c), each having a first (120ga-120gc) and a second (120va-120vc) power supply contact for providing, respectively, a first and a second binary value, and means for supplying at least one identification bit of a version of the integrated device (100),
characterized in that it includes, for each identification bit, parity check means (135abi, 135bci) having a plurality of input terminals whose number is equal to the number of conducting layers (115a-115c), and an output terminal, each input terminal being connected to one contact selected from the first (120ga-120gc) and the second (120va-120vc) power supply contacts of a corresponding one of the conducting layers (115a-115c), and the output terminal supplying the corresponding identification bit.

2. Integrated device (100) according to Claim 1, wherein each conducting layer consists of a metal layer (115a-115c).

3. Integrated device (100) according to Claim 2, wherein each input terminal of the parity check means (135abi, 135bci) is connected to a connecting pad (140ai-140ci) of the corresponding metal layer (115a-115c), the connecting pad (140ai-140ci) being connected to the selected power supply contact (120ga-120gc; 120va-120vc).

4. Integrated device (100) according to any one of Claims 1 to 3, further comprising a read-only register (150) having at least one binary cell (150i) for storing the at least one identification bit, the output terminal of each of the parity check means being connected to a corresponding one of the binary cells (150i).

5. Integrated device (100) according to any one of Claims 1 to 4, wherein the parity check means consist of a combinatorial network (135abi, 135bci).

6. Integrated device (100) according to Claim 5, wherein the combinatorial network consists of at least one logical XOR gate (135abi, 135bci), whose number is equal to the number of the conducting layers (115a-115c) minus 1.

7. Integrated device (100) according to Claim 6, wherein the combinatorial network (135abi, 135bci) includes, for each conducting layer (115b, 115c) except for a first conducting layer (115a), a logical XOR gate (135abi, 135bci) having a first input terminal connected to an output terminal of a preceding one of the logical XOR gates and a second input terminal connected to the selected power supply contact (120gb-120gc; 120vb-120vc) of the corresponding conducting layer (115b, 115c), a first one of the logical XOR gates (135abi) having the first input terminal connected to the selected power supply contact (120ga; 120va) of the first conducting layer (115a) and the output terminal of a last one of the logical XOR gates (135bci) supplying the corresponding identification bit.

8. Method of identification comprising the steps of:
providing an integrated device (100) with a plurality of conducting layers (115a-115c), each having a first (120ga-120gc) and a second (120va-120vc) power supply contact for providing, respectively, a first and a second binary value, and
providing at least one identification bit of a version of the integrated device (100),
the method being characterized by the steps of:
providing, for each identification bit, parity check means (135abi, 135bci) having a plurality of input terminals whose number is equal to the number of conducting layers (115a-115c) and an output terminal, and
connecting each input terminal to one contact selected from the first (120ga-120gc) and the second (120va-120vc) power supply contacts of a corresponding one of the conducting layers (115a-115c), the output terminal supplying the corresponding identification bit.
